# EUROPÄISCHE PATENTSCHRIFT

(11) **EP 0 974 161 B1**
(45) Veröffentlichungstag und Bekanntmachung des Hinweises auf die Patenterteilung: **02.05.2007**
(21) Anmeldenummer: 99910085.2
(22) Anmeldetag: 27.01.1999
(51) Int. Cl.: H01L 21/761

(54) **HALBLEITERBAUELEMENT MIT STRUKTUR ZUR VERMEIDUNG VON QUERSTRÖMEN**
SEMICONDUCTOR COMPONENT WITH A STRUCTURE FOR PREVENTING ONSET OF CROSS CURRENTS
COMPOSANT A SEMICONDUCTEUR AVEC STRUCTURE EMPECHANT L'APPARITION DE COURANTS TRANSVERSAUX

(30) Priorität: 12.02.1998 DE 19805786
(43) Veröffentlichungstag der Anmeldung: 26.01.2000
(73) Patentinhaber: Infineon Technologies AG, 81669 München (DE)
(72) Erfinder: WERNER, Wolfgang, D-81545 München (DE)
(74) Vertreter: Patentanwälte Westphal, Mussgnug & Partner
(86) Internationale Anmeldenummer: PCT/DE1999/000214
(87) Internationale Veröffentlichungsnummer: WO 1999/041780

(56) Entgegenhaltungen:
- EP-A- 0 764 988
- GB-A- 2 175 138
- US-A- 5 179 432
- US-A- 5 485 027
- PATENT ABSTRACTS OF JAPAN vol. 097, no. 012, 25. Dezember 1997 -& JP 09 213787 A (ROHM CO LTD), 15. August 1997

## Beschreibung

Die vorliegende Erfindung bezieht sich auf ein Halbleiterbauelement, das ein Substrat von einem ersten Leitfähigkeitstyp aufweist, an dessen Oberfläche mehrere separate Wannen von einem zweiten Leitfähigkeitstyp mit einer höherdotierten Randschicht vom zweiten Leitfähigkeitstyp angeordnet sind, die durch pn-Übergänge voneinander getrennt sind.

Bei integrierten Leistungsschaltern, die in einer Mehrzahl von Wannen in der Oberfläche eines Halbleiters erzeugt sind, treten häufig Betriebszustände auf, bei denen das Potential der Drain-Elektrode eines DMOS-Transistors bezogen auf das Substratpotential negativ wird. Dabei werden Minoritätsträger (Elektronen) von mindestens einer der Wannen in das p⁻-dotierte Substrat injiziert. Aufgrund der sehr hohen Trägerlebensdauer im Substrat ist die Reichweite dieser Minoritätsträger sehr hoch (einige mm). Jede im Kristall befindliche weitere n-Wanne wirkt als Kollektor bzw. als Senke für diese Minoritätsträger. Die in den weiteren n-Wannen befindlichen Bauelemente (pMOS, nMOS, PNP's, NPN's etc.) werden durch diese parasitären Ströme in ihrer Funktion beeinträchtigt, was zum Funktionsausfall der Schaltung führen kann. Die injizierende Wanne (Emitter), das Substrat (Basis) und jede weitere Wanne (Kollektor) bilden also einen NPN-Transistor. Der durch diesen NPN-Transistor fließende Strom wird "Querstrom" genannt.

Ein isolierter Leistungstransistor ist in EP 764 988 beschrieben.

In DE 44 11 869 ist eine Struktur beschrieben, bei der der Querstrom durch zwei Maßnahmen unterdrückt wird. Die erste Maßnahme besteht darin, daß Absaugringe um das injizierende bzw. das den Emitter bildende Bauelement herum angeordnet werden und mit dem Source-Anschluß des DMOS-Transistors verbunden werden. Die zweite Maßnahme besteht darin, daß ein p⁺-p⁻-Substrat verwendet wird. Die Absaugringe wirken als Kollektor, so daß die weiteren Wannen praktisch keinen Querstrom mehr aufnehmen können. Durch den Dotierungsgradienten zwischen p⁺-Gebiet und p⁻-Gebiet im Substrat wird ein Driftfeld aufgebaut, das die Injektion der Minoritätsträger in das Substrat verhindert.

Obgleich sich diese Struktur als wirkungsvoll zur Unterdrükkung von Querströmen erwiesen hat, weist sie jedoch zwei nicht unerhebliche Nachteile auf. Erstens ist das erforderliche p⁺- bzw. p⁺-p⁻-Substrat teurer als das p⁻-Substrat, das standardmäßig verwendet wird. Zweitens kann ein vorhandenes Schaltungsdesign nicht ohne einschneidende Korrekturen am Layout querstromsicher gemacht werden: es müssen die Absaugringe vorgesehen werden. Und schließlich wird durch die Absaugringe eine größere Chipfläche erforderlich, dies um so mehr, als vergleichsweise große Ströme abgeführt werden müssen, die größer als der Nennstrom des Bauelements werden können und bis zu 10A betragen können.

Aufgabe der Erfindung ist es daher, ein Halbleiterbauelement anzugeben, das so aufgebaut ist, daß durch in das Substrat injizierte Minoritätsträger die einzelnen Wannen im Bauelement nicht beeinflußt werden, sowie ein Verfahren zur Herstellung eines solchen Halbleiterbauelements anzugeben.

Diese Aufgabe wird gelöst durch ein Halbleiterbauelement mit den Merkmalen nach Anspruch 1 bzw. ein Herstellungsverfahren mit dem Merkmalen nach Anspruch 5. Die abhängigen Ansprüche beziehen sich auf bevorzugte Ausführungsformen der Erfindung.

Durch die Erfindung wird verhindert, daß im Substrat befindliche Minoritätsträger in die Wannen in großer Zahl eindringen bzw. daß Minoritätsträger aus den Wannen überhaupt in das Substrat gelangen und somit Querströme entstehen können.

Das erfindungsgemäße Halbleiterbauelement, das ein Substrat von einem ersten Leitfähigkeitstyp aufweist, an dessen Oberfläche mehrere separate Wannen von einem zweiten Leitfähigkeitstyp mit einer höherdotierten Randschicht vom zweiten Leitfähigkeitstyp angeordnet sind, die durch pn-Übergänge voneinander getrennt sind, ist dadurch gekennzeichnet, daß mindestens eine der Wannen von einer Isolierwanne vom ersten Leitfähigkeitstyp vollständig umgeben ist, wobei die Dotierung der Isolierwanne höher als die des Substrats ist. Die von einer Isolierwanne umgebenen Wannen können dabei sowohl Minoritätsträger injizierende als auch Minoritätsträger aufnehmende Wannen sein. Dadurch, daß die Dotierung der Isolierwanne höher als die des Substrats ist, baut sich zwischen dem Substrat und der Substratzusatzschicht ein Gegenfeld auf, das die Minoritätsträger am weiteren Eindringen in die Isolierwanne hindert.

Eine bevorzugte Ausführungsform des Halbleiterbauelements besteht darin, daß die Isolierwanne eine Substratzusatzschicht auf dem Substrat und eine Seitenwand zwischen der Substratzusatzschicht und der Oberfläche des Halbleiters umfaßt.

Bei beiden Ausführungsformen wird die Wanne durch die Isolierwanne mit Substratzusatzschicht und Seitenwand vom jeweils ersten Leitfähigkeitstyp im Halbleiter gegen den übrigen Halbleiter, also insbesondere gegen die übrigen Wannen im Halbleiter "hermetisch" abgeschirmt, so daß Querströme von der abgeschirmten Wanne nicht mehr ausgehen können oder diese nicht mehr erreichen können.

Das Halbleiterbauelement kann zwischen der Substratzusatzschicht und der Randschicht eine Abstandsschicht vom ersten Leitfähigkeitstyp aufweisen, die schwächer dotiert ist als die Substratzusatzschicht oder die Seitenwand, so daß die Spannungsfestigkeit des Bauelements gewährleistet ist. Die Abstandsschicht kann dabei zwei oder mehrere Teilschichten umfassen, so daß die Spannungsfestigkeit je nach Anzahl der Teilschichten eingestellt werden kann.

Das erfindungsgemäße Verfahren zum Herstellen eines Halbleiterbauelements, das die Schritte umfaßt: Erzeugen mehrerer separater Wannen an der Oberfläche des Halbleiterbauelements auf einem Substrat, wobei das Substrat von einem ersten Leitfähigkeitstyp und die mehreren Wannen von einem zweiten Leitfähigkeitstyp sind und die Wannen eine höherdotierte Randschicht vom zweiten Leitfähigkeitstyp aufweisen, und Erzeugen von Anschluß- und Steuer-Elektroden in den Wannen zum Herstellen von Bauelement-Strukturen, ist gekennzeichnet durch das Erzeugen einer Isolierwanne vom ersten Leitfähigkeitstyp um jeweils mindestens eine der Wannen, wobei die Dotierung der Isolierwanne höher als die des Substrats ist.

Insbesondere kann zum Erzeugen der Isolierwanne eine Substratzusatzschicht auf dem Substrat und eine mit der Substratzusatzschicht zusammenhängende vertikale Seitenwand zwischen den Wannen erzeugt werden.

Vorzugsweise wird bei dem erfindungsgemäßen Verfahren eine Abstandsschicht vom ersten Leitfähigkeitstyp zwischen der Isolierwanne und der Randschicht erzeugt, die schwächer dotiert ist als die Isolierwanne.

Weitere Merkmale und Vorzüge der Erfindung ergeben sich aus der Beschreibung von zeichnerisch dargestellten Ausführungsformen der Erfindung, die nur als Beispiel dienen, ohne daß die Erfindung auf diese eingeschränkt wäre.

Fig. 1 zeigt eine erste Ausführungsform eines erfindungsgemäß aufgebauten Halbleiterbauelements.

Fig. 2 zeigt eine zweite Ausführungsform eines erfindungsgemäß aufgebauten Halbleiterbauelements.

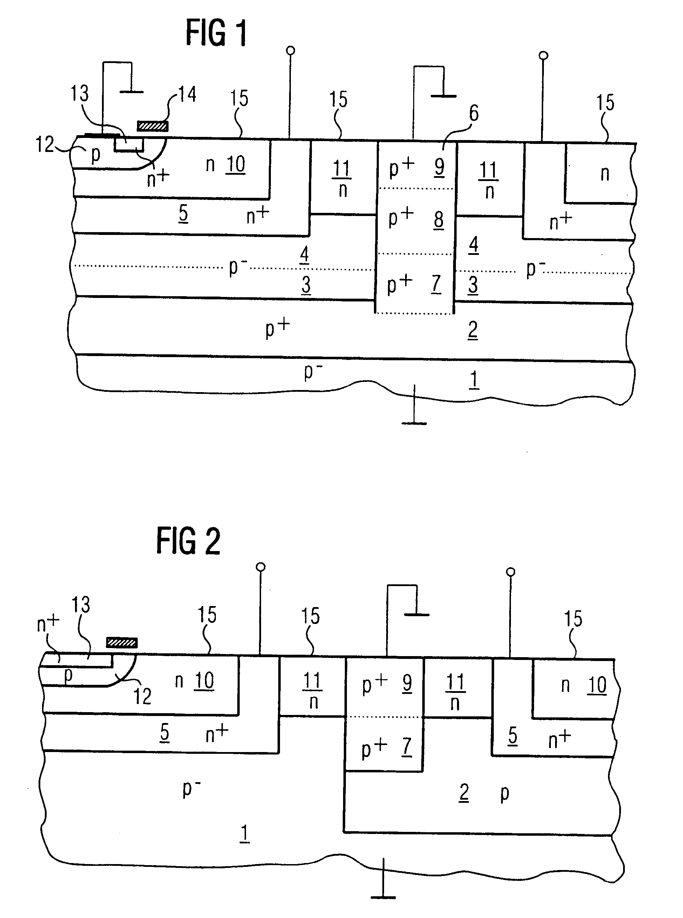

Erfindungsgemäß wird eine Struktur vorgeschlagen, die wie in Fig. 1 dargestellt ein p⁻-Standardsubstrat 1 als Ausgangsmaterial umfaßt, das mit mehreren Schichten bedeckt ist, wobei in der Oberfläche der Schichtstruktur mehrere Wannen 10 erzeugt sind. Die Wannen 10, von denen jeweils eine in Fig. 1 und Fig. 2 am linken und am rechten Rand gezeigt ist, sind n-dotiert. Sie dienen der Aufnahme der einzelnen Halbleiterschalter-Elemente, die in Fig. 1 und Fig. 2 als DMOS-Transistor angedeutet sind. Dabei ist die erste Diffusion des DMOS-Transistors, die p-dotiert ist und den Kanal des DMOS-Transistors definiert, mit 12, die zweite Diffusion des DMOS-Transistors, die n⁺-dotiert ist und als Source-Anschluß wirkt, mit 13 und die Gate-Elektrode des DMOS-Transistors mit 14 bezeichnet.

Beim Betreiben des DMOS-Transistors kann es zu einer Situation kommen, in der die Source-Elektrode auf Masse-Potential liegt und der Drain-Anschluß des DMOS-Transistors auf negativem Potential. Das führt wie oben beschrieben dazu, daß Elektronen als Minoritätsträger vom Drain-Anschluß in das Substrat driften, insbesondere, wenn wie in Fig. 1 und 2 gezeigt das Substrat auf Masse-Potential liegt.

Bei dem Aufbau der in Fig. 1 gezeigten Ausführungsform eines erfindungsgemäßen Halbleiterschalters wird das p⁻-dotierte Substrat 1 ganzflächig mit einer Substratzusatzschicht oder p⁺-Diffusion 2 belegt. Die Dicke des Substrats 1 beträgt normalerweise 500 µm, die der p'-Diffusion 2 vorzugsweise 10 bis 20 µm.

Auf die p⁺-Diffusion 2 wird wenigstens eine Abstandsschicht 3, insbesondere als Epitaxieschicht aufgebracht, die p-dotiert ist und deren Dotierung damit geringer als die der p⁺-Diffusion 2 ist. Die p⁺-Diffusion 2 dient dazu, mit der p-Epitaxieschicht 3 ein Dotierungsgefälle zu erzeugen. Damit werden (Minoritäts-) Ladungsträger, die von einer der n-dotierten Wannen injiziert werden, daran gehindert, in das p⁻-Substrat tiefer einzudringen und sich über einen großen Bereich zu verteilen, wo sie dann schwer abgesaugt werden können.

Statt einer Epitaxieschicht 3 mit geringer Dicke können auch zwei Epitaxieschichten 3 und 4 oder eine Epitaxieschicht 3 mit größerer Dicke vorgesehen werden, wenn dies die Spannungsfestigkeit des Bauelements erfordert. Durch mehrere Epitaxieschichten wird der für eine höhere Spannungsfestigkeit erforderliche Abstand zu den Schichten an der Oberfläche des Halbleiterbauelements erhöht und so ein Durchbruch bei niedrigen Spannungen verhindert. In Fig. 1 sind zwei Epitaxieschichten 3 und 4 durch eine gestrichelte Linie voneinander getrennt dargestellt. Ihre Dicke richtet sich nach der gewünschten Spannungsfestigkeit des Bauelements.

Auf der Epitaxieschicht 3 bzw. 4 befindet sich eine vergrabene Schicht oder ein buried layer 5, der bis an die Oberfläche des Halbleiters 15 hochgezogen ist. Die vergrabene Schicht 5 ist n'-dotiert und damit höher dotiert als die Wanne 10. Sie bildet eine Randschicht der Wanne 10 an der Oberfläche 15 des Halbleiters und grenzt diese nach unten gegen das Substrat und an der Oberfläche 15 des Halbleiters gegen eine n-dotierte Oberflächenschicht 11 ab. Die Oberflächenschichten 15, die wie die Wannen n-dotiert sind, entstehen bei der Herstellung der Wannen an der Oberfläche 15 des Halbleiters.

Erfindungsgemäß wird in der Oberflächenschicht 11 und in der einen oder den mehreren Epitaxieschichten 3 und 4 eine Seitenwand 6 als Teil einer Isolierwanne von demselben Leitfähigkeitstyp wie das Substrat 1 erzeugt, vorzugsweise durch Diffusion, aber auch eine Erzeugung durch Implantation ist möglich. Die Dotierung der Seitenwand ist vorzugsweise hoch, so daß das Gebiet 6 in Fig. 1 und Fig. 2 mit p⁺ bezeichnet ist. Die Seitenwand 6 hat damit in der dargestellten Ausführungsform eine vergleichbare Dotierung wie die p⁺-Diffusion.

Die Tiefe der Seitenwand 6 in dem Halbleiter hängt von dem Abstand der p⁺-Diffusion 2 von der Oberfläche 15 des Halbleiters ab, der durch die gewünschte Spannungsfestigkeit des Bauelements gegeben ist. Bei geringerer Spannungsfestigkeit, also bis ca. 30 V, kann die untere Isolator-Diffusion 7 in dem vertikal angeordneten p⁺-Gebiet 6 durch weitere Ausdiffusion in das horizontal angeordnete p⁺-Gebiet 2 ausgedehnt werden. Bei höheren Spannungsfestigkeiten, also ab ca. 60 V muß zwischen der ersten Isolator-Diffusion 7 und der Isolator-Diffusion 9 an der Oberfläche 15 eine weitere maskierte Isolator-Diffusion 8 vorgesehen werden, um die notwendige Ausdehnung der vertikal angeordneten p⁺-Seitenwand 6 bis zur p⁺-Diffusion 2 sicherzustellen.

So ist bei dem Halbleiter nach Fig. 1 mit der Epitaxieschicht 3 und 4 eine Seitenwand 6 mit drei Schichten 7, 8 und 9 notwendig, um die Verbindung zwischen Oberfläche 15 und p⁺-Diffusion 2 herzustellen: die erste Isolator-Diffusion 7 wird in Verbindung mit der ersten Epitaxieschicht 3 erzeugt, die zweite Isolator-Diffusion 8 wird in Verbindung mit der zweiten Epitaxieschicht 4 erzeugt, und die dritte Isolator-Diffusion 9 wird in Verbindung mit der Oberflächenschicht 11 bei der Herstellung der Wannen 10 erzeugt. Bei der Diffusion der einzelnen Schichten 7, 8, 9 des Seitenwand 6 kommt es zu Verschiebungen der Grenzen der einzelnen Schichten in der Seitenwand 6, so daß diese nicht in gleicher Höhe den benachbarten Schichten dargestellt sind.

Die Seitenwand 6 mündet in die p⁺-Diffusion 2, so daß eine hermetische Abschirmung der Wannen 10 und ihrer Umgebung gegenüber einander erfolgt und kein Querstrom von einer dieser Wannen 10 in das Substrat 1 injiziert werden kann oder eine dieser Wannen 10 von einem Querstrom in dem Substrat 1 gestört werden kann.

Aufgrund der Dotierungsverhältnisse wird damit bei der erfindungsgemäßen Struktur der bei negativen Potential an der ersten Wanne fließende Strom nicht ins Substrat sondern in das body-Gebiet des DMOS-Transistors abfließen, da dort eine kleinere pn-Schwelle zu überwinden ist als zum Substrat hin.

Weitere Ladungsträger, die in das p⁺-Gebiet 2 bzw. 6 gelangen, werden wie in Fig. 1 und Fig. 2 dargestellt zur Masse abgeführt.

Fig. 2 zeigt eine weitere Ausführungsform der erfindungsgemäßen Struktur, die sich dadurch von der Ausführungsform nach Fig. 1 unterscheidet, daß eine (horizontale) p⁺- oder p-Diffusion 2 nur unter den querstromgefährdeten weiteren n-Wannen 10 angeordnet ist (während bei der Ausführungsform nach Fig. 1 das Substrat 1 ganzflächig mit einer p⁺-Diffusion bedeckt wird). Dies wird durch eine maskierte Diffusion des horizontalen p⁺- oder p-Gebietes 2 erreicht. Dadurch ist es möglich, nur einige Wannen selektiv gegen Querströme im Substrat zu schützen.

Bei dieser Ausführungsform der Erfindung ist es nicht unbedingt erforderlich, daß die Diffusion 2 hoch dotiert ist. Es ist aber vorteilhaft, wenn die Diffusion einen höheren Dotierungsgrad als das p⁻-Substrat aufweist. Aufgrund des Driftfeldes zwischen p⁻-Substrat 1 und dem p-Gebiet 2 unter der n-Wanne 10 nimmt das p-Gebiet 2 weit weniger Minoritätsträger auf als ohne p-Diffusion.

Da außerdem die Wannen 10 häufig nur geringe Spannungen sehen, die z. B. bei Mehrfach-low-side-Schaltern unter ca. 20 V liegen, kann die vertikale Ausdehnung des p⁻-Gebietes 3 bzw. 3 und 4 in Fig. 1 zwischen der n⁺-dotierten vergrabenen Schicht (buried layer) 5 und dem horizontalen p⁺-Gebiet 2 sehr klein gemacht werden oder das p⁺-Gebiet ganz entfallen. Die Epitaxieschichten 3 und 4 zwischen dem n⁺-dotierten buried layer 5 und dem p⁺-Gebiet 6, wie sie in der Ausführungsform nach Fig. 1 zur Erzeugung eines Driftfeldes zum Einschließen von Minoritätsträgern in obere Schichten des Halbleiters vorgesehen waren, sind daher bei der Ausführungsform nach Fig. 2 nicht mehr dargestellt.

Die weiteren Elemente in Fig. 2, die die gleichen Bezugszeichen wie in Fig. 1 haben, haben die bereits in Verbindung mit der Ausführungsform nach Fig. 1 erläuterte Funktion.

Zur Fertigstellung des Power IC's, d. h. zur Herstellung der Strukturen der DMOS-Transistoren in den einzelnen Wannen 10, kann anschließend an die obigen Schritte des erfindungsgemäßen Verfahrens der entsprechende Standard-BCD-Prozeß (Bipolar-/CMOS-/DMOS-Technologie) beginnend mit unterer Isolationsdiffusion oder der buried layer-Diffusion durchgeführt werden.

Mit der Erfindung wird damit eine Vorrichtung geschaffen, die zuverlässig und bei geringen Kosten Querströme vermeidet.

## Patentansprüche

1. Halbleiterbauelement, das ein Substrat (1) von einem ersten Leitfähigkeitstyp aufweist, an dessen Oberfläche (15) mehrere separate Wannen (10) von einem zweiten Leitfähigkeitstyp mit einer höherdotierten Randschicht (5) vom zweiten Leitfähigkeitstyp angeordnet sind, die durch pn-Übergänge voneinander getrennt sind,
**dadurch gekennzeichnet, daß**
mindestens eine der Wannen (10) von einer Isolierwanne (2, 6) vom ersten Leitfähigkeitstyp vollständig umgeben ist, wobei die Dotierung der Isolierwanne (2, 6) höher als die des Substrats (1) ist.

2. Halbleiterbauelement nach Anspruch 1,
**dadurch gekennzeichnet, daß**
die Isolierwanne (2, 6) eine Substratzusatzschicht (2) auf dem Substrat (1) und eine Seitenwand (6) zwischen der Substratzusatzschicht (2) und der Oberfläche des Halbleiters (15) umfaßt.

3. Halbleiterbauelement nach Anspruch 2,
**dadurch gekennzeichnet, daß**
zwischen der Substratzusatzschicht (2) und der Randschicht (5) eine Abstandsschicht (3, 4) von dem ersten Leitfähigkeitstyp angeordnet ist, die schwächer dotiert ist als die Substratzusatzschicht (2) oder die Seitenwand (6) der Isolierwanne.

4. Halbleiterbauelement nach Anspruch 3,
**dadurch gekennzeichnet, daß**
die Abstandsschicht (3, 4) zwei Teilschichten umfaßt.

5. Verfahren zum Herstellen eines Halbleiterbauelements, das die Schritte umfaßt:
Erzeugen mehrerer separater Wannen (10) an der Oberfläche (15) des Halbleiterbauelements auf einem Substrat (1), wobei das Substrat (1) von einem ersten Leitfähigkeitstyp und die mehreren Wannen (10) von einem zweiten Leitfähigkeitstyp sind und die Wannen eine höherdotierte Randschicht (5) vom zweiten Leitfähigkeitstyp aufweisen,
Erzeugen von Anschluß- und Steuer-Elektroden (12, 13, 14) in den Wannen (10) zum Herstellen von Bauelement-Strukturen,
**gekennzeichnet durch**
Erzeugen einer Isolierwanne (2, 6) vom ersten Leitfähigkeitstyp um jeweils mindestens eine der Wannen (10), deren Dotierung höher als die des Substrats (1) ist.

6. Verfahren nach Anspruch 5,
**dadurch gekennzeichnet, daß**
zum Erzeugen der Isolierwanne (2, 6) eine Substratzusatzschicht (2) auf dem Substrat (1) und eine mit der Substratzusatzschicht (2) zusammenhängende vertikale Seitenwand (6) zwischen den Wannen (10) erzeugt wird.

7. Verfahren nach Anspruch 6,
**gekennzeichnet durch**
Erzeugen einer Abstandsschicht (3, 4) vom ersten Leitfähigkeitstyp zwischen der Isolierwanne (2, 6) und der Randschicht (5), die schwächer dotiert ist als die Isolierwanne (2, 6).

## Claims

1. Semiconductor component having a substrate (1) of a first conductivity type, at the surface (15) of which a plurality of separate wells (10) of a second conductivity type with a more highly doped edge layer (5) of the second conductivity type are arranged, which are isolated from one another by pn junctions,
**characterized in that**
at least one of the wells (10) is completely surrounded by an insulating well (2, 6) of the first conductivity type, the doping of the insulating well (2, 6) being higher than that of the substrate (1).

2. Semiconductor component according to Claim 1,
**characterized in that**
the insulating well (2, 6) comprises a substrate supplementary layer (2) on the substrate (1) and a side wall (6) between the substrate supplementary layer (2) and the surface of the semiconductor (15).

3. Semiconductor component according to Claim 2,
**characterized in that**
a spacer layer (3, 4) of the first conductivity type is arranged between the substrate supplementary layer (2) and the edge layer (5), and is more weakly doped than the substrate supplementary layer (2) or the side wall (6) of the insulating well.

4. Semiconductor component according to Claim 3,
**characterized in that**
the spacer layer (3, 4) comprises two partial layers.

5. Method for fabricating a semiconductor component, which comprises the following steps:
production of a plurality of separate wells (10) at the surface (15) of the semiconductor component on a substrate (1), the substrate (1) being of a first conductivity type and the plurality of wells (10) being of a second conductivity type and the wells having a more highly doped edge layer (5) of the second conductivity type,
production of connection and control electrodes (12, 13, 14) in the wells (10) for the purpose of fabricating component structures,
**characterized by**
production of an insulating well (2, 6) of the first conductivity type around in each case at least one of the wells (10), whose doping is higher than that of the substrate (1).

6. Method according to Claim 5,
**characterized in that**
in order to produce the insulating well (2, 6), a substrate supplementary layer (2) is produced on the substrate (1) and a vertical side wall (6) contiguous with the substrate supplementary layer (2) is produced between the wells (10).

7. Method according to Claim 6,
**characterized by**
production of a spacer layer (3, 4) of the first conductivity type between the insulating well (2, 6) and the edge layer (5), which is more weakly doped than the insulating well (2, 6).

## Revendications

1. Composant semi-conducteur qui présente un substrat (1) d'un premier type de conductibilité, dont la surface (15) comporte plusieurs cuvettes (10) distinctes ayant un second type de conductibilité et une couche marginale (5) fortement dopée du second type de conductibilité, séparées l'une de l'autre par des jonctions pn,
**caractérisé en ce qu'**
au moins une des cuvettes (10) est entourée par une cuvette d'isolation (2, 6) du premier type de conductibilité, le dopage de la cuvette d'isolation (2, 6) étant supérieur à celui du substrat (1).

2. Composant semi-conducteur selon la revendication 1,
**caractérisé en ce que**
la cuvette d'isolation (2, 6) comprend une couche supplémentaire de substrat (2) sur le substrat (1) et une paroi latérale (6) entre la couche supplémentaire de substrat (2) et la surface du semiconducteur (15).

3. Composant semi-conducteur selon la revendication 2,
**caractérisé en ce qu'**
une couche de séparation (3, 4) du premier type de conductibilité entre la couche supplémentaire de substrat (2) et la couche marginale (5), est dopée plus faiblement que la couche supplémentaire de substrat (2) ou la paroi latérale (6) de la cuvette d'isolation.

4. Composant semi-conducteur selon la revendication 3,
**caractérisé en ce que**
la couche de séparation (3, 4) comprend deux couches partielles.

5. Procédé de fabrication d'un composant semi-conducteur qui comprend les étapes consistant à :
produire sur un substrat (1) plusieurs cuvettes distinctes (10) à la surface (15) du composant semi-conducteur, le substrat (1) étant d'un premier type de conductibilité, et les multiples cuvettes (10) ayant un second type de conductibilité et une couche marginale (5) du second type de conductibilité, fortement dopée, et
produire des électrodes de connexion et de commande (12, 13, 14) dans les cuvettes (10) pour fabriquer des structures de composants,
**caractérisé par**
la création d'une cuvette d'isolation (2, 6) du premier type de conductibilité, entourant au moins une des cuvettes (10) et dont le dopage est supérieur à celui du substrat (1).

6. Procédé selon la revendication 5,
**caractérisé en ce que**
pour produire la cuvette d'isolation (2, 6) une couche supplémentaire de substrat (2) est crée sur le substrat (1), et une paroi latérale (6) verticale est liée à la couche supplémentaire de substrat (2) entre les cuvettes (10).

7. Procédé selon la revendication 6,
**caractérisé par**
la création d'une couche de séparation (3, 4) du premier type de conductibilité, dopée plus faiblement que la cuvette d'isolation (2, 6), entre la cuvette d'isolation (2, 6) et la couche marginale (5).
